# EUROPEAN PATENT SPECIFICATION

(11) **EP 2 155 933 B1**
(45) Date of publication and mention of the grant of the patent: **14.09.2011**
(21) Application number: 08807153.5
(22) Date of filing: 10.06.2008
(51) Int. Cl.: C30B 29/36, C30B 9/00

(54) **METHOD FOR PRODUCING SIC SINGLE CRYSTAL**
VERFAHREN ZUR HERSTELLUNG EINES SiC-EINKRISTALLS
PROCÉDÉ DE FABRICATION DE MONOCRISTAUX DE SIC

(30) Priority: 11.06.2007 JP 2007153846
(43) Date of publication of application: 24.02.2010
(73) Proprietor: Toyota Jidosha Kabushiki Kaisha, Toyota-shi, Aichi-ken 471-8571 (JP)
(72) Inventor: SAKAMOTO, Hidemitsu, Toyota-shi Aichi-ken 471-8571 (JP)
(74) Representative: Duckworth, Timothy John
(86) International application number: PCT/IB2008/002494
(87) International publication number: WO 2008/155673

(56) References cited:
- EP-A- 1 498 518
- JP-A- 2007 076 986
- JP-A- 2007 153 719
- DMITRIEV ET AL: "Silicon carbide and SiC-AIN solid-solution p-n structures grown by liquid-phase epitaxy" PHYSICA B. CONDENSED MATTER, AMSTERDAM, NL, vol. 185, no. 1-4, 1 April 1993 (1993-04-01), pages 440-452, XP022721131 ISSN: 0921-4526 [retrieved on 1993-04-01]

## Description

### 1. Field of the Invention

The invention relates to a method for producing SiC single crystal using a solution.

### 2. Description of the Related Art

The energy band gap of silicon carbide (SiC) is larger than that of silicon (Si). Therefore, various methods for producing high-quality SiC single crystal suitable as a semiconductive material have been proposed. These methods are mainly classified into sublimation methods and solution methods. Having a relatively high polytype controllability and being effective to reduce micropipes, the solution methods have been attracting much attention of those in the art.

In a typical solution method, the temperature gradient of an Si melt in a graphite crucible is maintained such that the temperature decreases from the inner side of the Si melt toward its surface. Carbon (C) dissolves into the Si melt at a high-temperature area in the lower side of the graphite crucible, and it is then brought upward mainly by the convection current of the Si melt and reaches a low-temperature area near the surface of the Si melt, whereby C is supersaturated in the lower-temperature area. SiC seed crystal, which are put on the tips of graphite rods, are held immediately beneath the surface of the Si melt. During this time, epitaxial growth of the supersaturated C occurs on the SiC seed crystal, whereby SiC single crystal are obtained.

According to such solution methods, however, hillocks tend to be created on the growing surfaces of the crystal relatively easily. If hillocks are created, single crystal may grow from the hillocks separately, resulting in poly-crystallization. Therefore, independent single crystal having smooth growing surfaces can not be produced in a stable manner.

Japanese Patent Application Publication No. 2004-02173 (JP-A-2004-02173) describes a solution method in which SiC single crystal are produced using an Si melt to which titanium (Ti) or manganese (Mn) has been added to increase the dissolution amount of C to the Si melt and thereby accelerate the growing of the SiC single crystal. In this method, too, poly-crystallization occurs at some portions of each seed crystal, and therefore the growing surfaces of the crystal become unsmooth.

On the other hand, Japanese Patent Application Publication No. 2005-82435 (JP-A-2005-82435) proposes to add one of Al, Ga, In, As, Sb, Au, Ag, and Pt to an Si melt to enhance the smoothness of the growing surfaces of single crystal. This method, however, does not accelerate the growing of single crystal.

Further, Japanese Patent Application Publication No. 2006-69861 (JP-A-2006-69861) proposes adding at least one of Ti, Fe, Mn, and Co to an Si melt, Japanese Patent Application Publication No. 2000-264790 (JP-A-2000-264790) proposes adding a transition metal to an Si melt, and Japanese Patent Application Publication No. 2006-143555 (JP-A-2006-143555) proposes adding at least one of Fe and Co to an Si melt. All these techniques are used to facilitate dissolution of C into an Si melt and thus ensure both fast growing of single crystal and their smooth growing surfaces. However, none of these techniques satisfies these two requirements sufficiently.

Thus, none of the above related-art techniques achieves a high crystal growth speed and a high growing surface smoothness.

### SUMMARY OF THE INVENTION

The invention provides a method for producing silicon carbide (SiC) single crystal having a smooth growing surface at a high growth speed in a stable manner.

An aspect of the invention relates to a method for producing SiC single crystal, including: adding titanium (Ti) and a single element selected from the group consisting of tin (Sn) and germanium (Ge) to a silicon (Si) melt; and growing SiC single crystal from SiC seed crystal by holding the SiC seed crystal immediately beneath the surface of the Si melt in a graphite crucible while maintaining a temperature gradient descending from an inner side of the Si melt to the surface of the Si melt. In this method, the amount of Ti added to the Si melt is 5 to 30 at%, the amount of Ge selectively added to the Si melt is 1 to 30 at%, and the amount of Sn selectively added to the Si melt is 1 to 20 at%.

According to the method described above, the dissolvability of carbon (C) increases due to the Ti added to the Si melt, whereby the SiC single crystal growth speed increases, and owing to the surfactant property of Sn or Ge, the smoothness of the growing surface of each SiC single crystal is high.

The above-described SiC single crystal producing method may be such that a graphite crucible having a density of 1.85 g/cm₃ or higher is used as the graphite crucible when Sn is added to the Si melt. Further, the above-described SiC single crystal producing method may be such that a graphite crucible having a porosity of 18 % or lower is used as the graphite crucible when Sn is added to the Si melt. Further, the above-described SiC single crystal producing method may be such that the SiC seed crystal are 6H-SiC hexagonal crystal. Further, the above-described SiC single crystal producing method may be such that the temperature at the surface of the Si melt is 1800 to 1850 °C. Further, the above-described SiC single crystal producing method may be such that the temperature gradient descending from the inner side of the Si melt to the surface of the Si melt is 15 to 20 °C/cm. Further, the above-described SiC single crystal producing method may be such that the SiC single crystal are grown for 10 hours.

### BRIEF DESCRIPTION OF THE DRAWINGS

The foregoing and further objects, features and advantages of the invention will become apparent from the following description of embodiments with reference to the accompanying drawings, wherein like numerals are used to represent like elements and wherein:
FIGS. 1A, 1B, and 1C are pictures illustrating the criteria for rating the smoothness of the growing surfaces of SiC single crystal in the example of the invention; and
FIG. 2 is a table indicating the SiC single crystal growth speed and the growing surfaces smoothness in each test sample.

### DETAILED DESCRIPTION OF THE EMBODIMENTS

Hereinafter, an example of the invention will be described. In this example, SiC single crystal were produced using an Si-Ti-M-C quaternary solution ("M" is Sn or Ge) prepared by adding Ti and Sn or Ge to an Si-C2 binary solution, and as a result, a high growth-surface smoothness and a high growth speed were both achieved. The addition amounts of Ti, Sn, and Ge were as follows. Note that in this specification the amount of each additive to an Si melt is indicated with respect to the amount of the entire Si melt.

Ti increases the amount of C dissolving from a graphite crucible to an Si melt and thereby accelerates the growing of single crystal. To obtain this effect, the addition amount of Ti needs to be at least 5 at% with respect to the amount of the entire Si melt. However, adding too much Ti to the Si melt may result in resultant single crystal having unsmooth growing surfaces. Thus, the addition amount of Ti was set to 30 at% or lower. That is, if more than 30 at% of Ti is added to an Si melt, a number of hillocks are easily created on seed crystal and thus the growing surfaces of resultant single crystal become unsmooth unless the gradient of the temperature of the Si melt is maintained very small, which requires extremely precise temperature control. In this case, therefore, it is difficult to produce single crystal having smooth growing surfaces. In view of this, in the example of the invention, the addition amount of Ti was set in the range of 5 to 30 at%.

Having surfactant properties (interface activating properties), Sn and Ge activate the growing surfaces of single crystal, facilitating the smoothening of said surfaces. If Ti is added to the Si melt as mentioned above, the concentration of C in the Si melt increases, and therefore the supply rate of C increases accordingly. This, however, only leads to an increase in the precipitation amount of SiC single crystal, not reducing the difficulty of ensuring the smooth-surface growing of the single crystal. That is, also in a case where an Si melt having a relatively high C concentration due to Ti contained therein is used, it is possible to minimize production of hillocks by activating the growing surfaces of crystal by a surfactant effect. By doing so, stable growing of each single crystal can be ensured.

To achieve this effect, the addition amounts of Sn or Ge were both set to 1 at% or higher with respect to the amount of the entire Si melt. However, because adding too much Sn or Ge may inhibit the smooth-surface growing of single crystal, the addition amount of Sn was set within a range up to 20 at% or the addition amount of Ge was set within a range up to 30 at%. That is, the addition amount Sn was set in the range of 1 to 20 at%, or the addition amount of Ge was set in the range of 1 to 30 at%.

It is considered that, due to the surfactant effect, the solid liquid interface energy decreases (the solution surface energy also decreases) and further the atomic migration at terrace surfaces of the growing surfaces of single crystal is facilitated, whereby a high growth speed and a high smoothness of the growing surfaces (two-dimensional growth) are both achieved. Although the aforementioned surfactant effect is considered to be produced mainly by Sn or Ge, it is considered that said effect is also produced by the synergy between Ti and Sn or by the synergy between Ti and Ge. On the other hand, if Ti is not added to the Si melt, that is, if only Sn or Ge is added to the Si melt, although the growing surfaces of single crystal can be made smooth by making the gradient of the temperature of the Si melt relatively small, the growth speed of the single crystal is low because the C concentration in the Si melt is not sufficiently high. Even if the temperature gradient of the Si melt is increased to increase the degree of supersaturation of C, the surfactant effects of Sn or Ge are not strong enough to ensure smooth growing surfaces of resultant single crystal alone.

The added Ti and Sn or Ge are contained as impurities in the SiC single crystal in the form of solid solutions, but their amounts are extremely small. More specifically, their total amount is approx. 10¹⁴ to 10¹⁵ atoms/cm³. Further, because Ti, Sn, and Ge are electrically inactive, the SiC single crystal produced according to this example of the invention can be used in various applications, such as high-frequency elements, substrate for GaN epitaxial growth, and so on. That is, they can be used to produce semi-insulators (semi-insulating substrates). Further, if n-type dopant, such as N (nitrogen), is contained in the SiC single crystal in the form of a solid solution, said crystal can be used to produce n-type semiconductors.

In this example of the invention, when adding Sn to the Si melt, a graphite crucible having a density of at least 1.85 g/cm³, which is higher than normal; may be used. If a graphite crucible having a density lower than 1.85 g/cm³ is used, there is a possibility that the Si melt will seep out of the graphite crucible. In the experiment by the present inventors, when a 1.7 g/cm³ graphite crucible was used, the Si melt entirely seeped out. That is, when the density of the graphite crucible is 1.85 g/cm³ or higher, the porosity of the graphite crucible is 18 % or lower, and therefore the seeping-out of the Si melt can be effectively prevented. On the other hand, in the case where Sn is not added to the Si melt, a graphite crucible having a density of approx. 1.6 g/cm³ may be used.

SiC single crystal were grown using an Si melt containing Ti, an Si melt containing Ti and Sn, and an Si melt containing Ti and Ge, respectively, as described below.

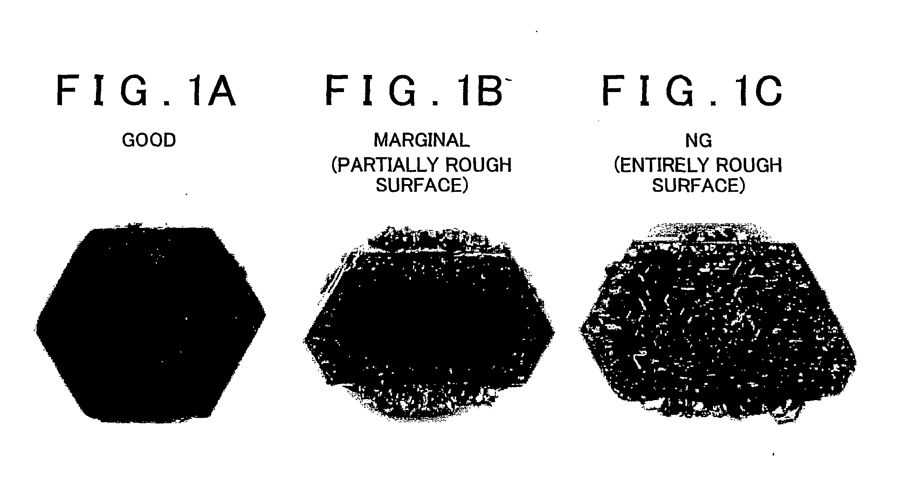

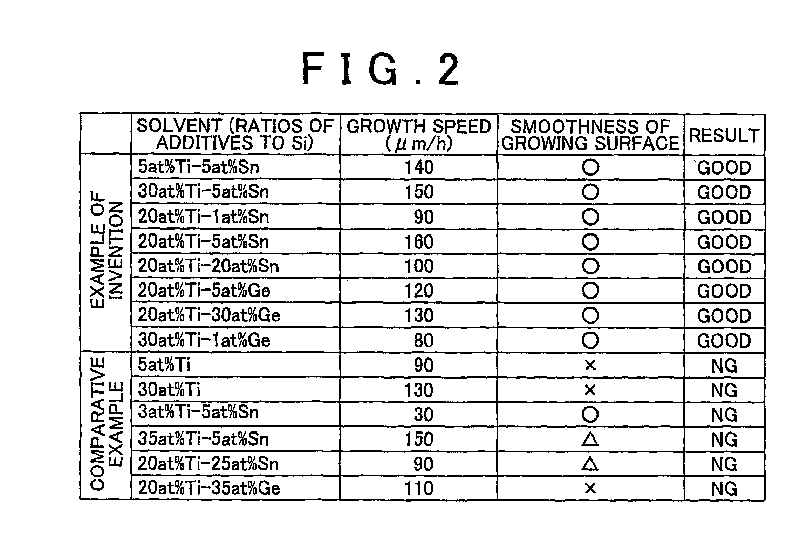

In the example of the invention, SiC single crystal were produced under the following conditions: 6H-SiC lely-crystal were used as seed crystal; the growth temperature (the temperature of the surface of the Si melt during the growing of SiC single crystal) was set in the range of 1800 to 1850 °C; the Si melt temperature gradient (the descending temperature gradient from the inner side of the Si melt to its surface) was kept in the range of 15 to 20 °C/cm; and the crystal growth duration was 10 hours. The table in FIG. 2 indicates the SiC single crystal growth speed and the growing surface smoothness of each test sample. The growing surface smoothness of each test sample was visually examined. FIGS. 1A, 1B, and 1C show respectively examples of the growing surfaces rated as "GOOD" (smooth), "MARGINAL" (partially poly-crystallized), and "NG" (entirely poly-crystallized) in the visual examination. In FIG. 1A, white lines are streaks of macro-step-flow growth, not cracks.

As is evident from the results shown in the table of FIG. 2, the test samples obtained using Si melts containing Ti and Sn or Ge of amounts in the ranges specified in the example of the invention achieved both a high growth speed and a high growing-surface smoothness ("GOOD"). On the other hand, the test samples obtained using Si melts containing Ti and Sn or Ge of amounts out of the ranges specified in the example of the invention failed to achieve at least one of a high growth speed and a high growing-surface smoothness. While 6H-SiC was used as seed crystal in the example of the invention, other crystal, such as 4H-SiC, may alternatively be used. In such a case, the growth temperature and the Si melt temperature gradient may be changed as needed.

While the invention has been described with reference to what are considered to be preferred embodiments thereof, it is to be understood that the invention is not limited to the disclosed embodiments or constructions. On the contrary, the invention is intended to cover various modifications and equivalent arrangements. In addition, while the various elements of the disclosed invention are shown in various combinations and configurations, which are exemplary, other combinations and configurations, including more, less or only a single element, are also within scope of the invention.

## Claims

1. A method for producing SiC single crystal, **characterized by** comprising:
adding Ti and a single element selected from the group consisting of Sn and Ge to an Si melt; and
growing SiC single crystal from SiC seed crystal by holding the SiC seed crystal immediately beneath the surface of the Si melt in a graphite crucible while maintaining a temperature gradient descending from an inner side of the Si melt to the surface of the Si melt, wherein
the amount of Ti added to the Si melt is 5 to 30 at%,
the amount of Ge selectively added to the Si melt is 1 to 30 at%, and
the amount of Sn selectively added to the Si melt is 1 to 20 at%.

2. The method according to claim 1, wherein the single element selected from the group consisting of Sn and Ge is Sn.

3. The method according to claim 1, wherein the single element selected from the group consisting of Sn and Ge is Ge.

4. The method according to claim 1 or 2, wherein a graphite crucible having a density of 1.85 g/cm₃ or higher is used as the graphite crucible when Sn is added to the Si melt.

5. The method according to claim 1 or 2, wherein a graphite crucible having a porosity of 18 % or lower is used as the graphite crucible when Sn is added to the Si melt.

6. The method according to any one of claims 1 to 5, wherein the SiC seed crystal are 6H-SiC hexagonal crystal.

7. The method according to claim 6, wherein the temperature at the surface of the Si melt is 1800 to 1850 °C.

8. The method according to claim 6 or 7, wherein the temperature gradient descending from the inner side of the Si melt to the surface of the Si melt is 15 to 20 °C/cm.

9. The method according to any one of claims 6 to 8, wherein the SiC single crystal are grown for 10 hours.

## Patentansprüche

1. Verfahren zum Erzeugen eine SiC-Einkristalls, **dadurch gekennzeichnet, dass** dieses umfasst:
Zugeben von Ti und einem einzelnen Element, das aus der Gruppe bestehend aus Sn und Ge ausgewählt ist, zu einer Si-Schmelze; und
Züchten des SiC-Einkristalls aus einem SiC-Impfkristall durch Positionieren des SiC-Impfkristalls unmittelbar unterhalb der Oberfläche der Si-Schmelze in einem Graphittiegel, während ein Temperaturgradient aufrechterhalten wird, der von der inneren Seite der Si-Schmelz zur Oberfläche der Si-Schmelze abnimmt, wobei die zu der Si-Schmelze hinzugefügte Ti-Menge 5 bis 30 Atom-% ist,
die zu der Si-Schmelze selektiv hinzugefügte Ge-Menge 1 bis 30 Atom-% ist, und
die zu der Si-Schmelze selektiv hinzugefügte Sn-Menge 1 bis 20 Atom-% ist.

2. Verfahren nach Anspruch 1, wobei das einzelne Element, das aus der Gruppe bestehend aus Sn und Ge ausgewählt ist, Sn ist.

3. Verfahren nach Anspruch 1, wobei das einzelne Element, das aus der Gruppe bestehend aus Sn und Ge ausgewählt ist, Ge ist.

4. Verfahren nach Anspruch 1 oder 2, wobei ein Graphittiegel mit einer Dichte von 1,85 g/cm³ oder mehr als Graphittiegel verwendet wird, wenn Sn zu der Si-Schmelze hinzugefügt wird.

5. Verfahren nach Anspruch 1 oder 2, wobei ein Graphittiegel mit einer Porosität von 18 % oder weniger als Graphittiegel verwendet wird, wenn Sn zu der Si-Schmelze hinzugefügt wird.

6. Verfahren nach einem der Ansprüche 1 bis 5, wobei der SiC-Impfkristall ein hexagonaler 6H-SiC-Kristall ist.

7. Verfahren nach Anspruch 6, wobei der Temperatur an der Oberfläche der Si-Schmelze 1800 bis 1850 °C ist.

8. Verfahren nach Anspruch 6 oder 7, wobei der Temperaturgradient, der von der Innenseite der Si-Schmelze zur Oberfläche der Si-Schmelze abnimmt, 15 bis 20 °C/cm ist.

9. Verfahren nach einem der Ansprüche 6 bis 8, wobei die SiC-Einkristalle für 10 Stunden gezüchtet werden.

## Revendications

1. Procédé de production d'un monocristal de SiC, **caractérisé en ce qu'**il comprend :
l'addition de Ti et d'un seul élément choisi dans le groupe constitué de Sn et de Ge à une masse fondue de Si ; et
la croissance d'un monocristal de SiC à partir d'un cristal de germe de SiC en maintenant le cristal de germe de SiC juste en dessous de la surface de la masse fondue de Si dans un creuset en graphite tout en maintenant un gradient de température descendant à partir d'un côté interne de la masse fondue de Si vers la surface de la masse fondue de Si, dans lequel
la quantité de Ti ajoutée à la masse fondue de Si est de 5 à 30 % at,
la quantité de Ge sélectivement ajouté à la masse fondue de Si est de 1 à 30 % at, et
la quantité de Sn sélectivement ajouté à la masse fondue de Si est de 1 à 20 % at.

2. Procédé selon la revendication 1, dans lequel le seul élément choisi dans le groupe constitué de Sn et de Ge est Sn.

3. Procédé selon la revendication 1, dans lequel le seul élément choisi dans le groupe constitué de Sn et de Ge est Ge.

4. Procédé selon la revendication 1 ou 2, dans lequel on utilise un creuset en graphite présentant une densité de 1,85 g/cm³ ou supérieure comme creuset en graphite lorsque l'on ajoute Sn à la masse fondue de Si.

5. Procédé selon la revendication 1 ou 2, dans lequel on utilise un creuset en graphite présentant une porosité de 18 % ou inférieure comme creuset en graphite lorsque l'on ajoute Sn à la masse fondue de Si.

6. Procédé selon l'une quelconque des revendications 1 à 5, dans lequel
le cristal de germe de SiC est un cristal hexagonal 6H-SiC.

7. Procédé selon la revendication 6, dans lequel la température à la surface de la masse fondue de Si est de 1 800 à 1 850°C.

8. Procédé selon la revendication 6 ou 7, dans lequel le gradient de température descendant du côté interne de la masse fondue de Si vers la surface de la masse fondue de Si est de 15 à 20°C/cm.

9. Procédé selon l'une quelconque des revendications 6 à 8, dans lequel le monocristal de SiC croît pendant 10 heures.
